# EUROPEAN PATENT APPLICATION

(11) **EP 1 921 457 A1**
(43) Date of publication of application: **14.05.2008**
(21) Application number: 06783017.4
(22) Date of filing: 18.08.2006
(51) Int. Cl.: G01R 27/02, G01R 35/00

(54) **INSULATION RESISTANCE DEGRADATION DETECTOR AND FAILURE SELF-DIAGNOSTIC METHOD FOR INSULATION RESISTANCE DEGRADATION DETECTOR**

(30) Priority: 29.08.2005 JP 2005247716
(71) Applicant: TOYOTA JIDOSHA KABUSHIKI KAISHA, Toyota-shi, Aichi-ken, 471-8571 (JP)
(72) Inventor: UCHIDA, Kenji, Toyota-shi Aichi 471-8571 (JP)
(74) Representative: TBK-Patent
(86) International application number: PCT/JP2006/316669
(87) International publication number: WO 2007/026603

(57) **Abstract**

An insulation resistance drop detector (50) includes a pulse generator (60) that applies a pulse signal (65) to a series circuit in which a detecting resistor (70), a coupling capacitor (80), and an insulating resistance (Ri) are serially connected. In a state where the pulse signal (65) is applied to the series circuit, control circuit (110) detects a pulse-like divided voltage occurring at a node (N1) by a voltage detecting circuit (100) via a bandpass filter (90), to thereby sense a drop of an insulation resistance (Ri). Further, the control circuit (110) senses a failure of the insulation resistance drop detector itself when the voltage detected by the voltage detecting circuit (100) is maintained at least at a prescribed voltage exceeding a plurality of cycles of the pulse signal (65). Thus, the insulation resistance drop detector having a failure self-diagnosis function is realized by a simple configuration.

## Description

### Technical Field

The present invention relates to an insulation resistance drop detector and a failure self-diagnosis method therefor, and particularly, to a failure self-diagnosis function of sensing a failure of an insulation resistance drop detector itself.

### Background Art

A power supply insulated from an earth, for example a battery (a direct-current power supply) incorporated in a vehicle such as an automobile (the earth corresponding to the vehicle), must be provided with a circuit for detecting a drop of an insulation resistance between the power supply and the earth.

As such an insulation resistance drop detector, Japanese Patent Laying-Open No. 10-290529 (hereinafter referred to as Patent Document 1) discloses a configuration of an insulation resistance drop detector that is applicable to an electric vehicle having a high-voltage power supply.

Japanese Patent Laying-Open No. 2005-114496 (hereinafter referred to as Patent Document 2) discloses a configuration of an insulation resistance drop detector, wherein a coupling capacitor connects a direct-current power supply and an insulation resistance drop detector while shutting off direct-current components. With the insulation resistance drop detector disclosed in Patent Document 2, a drop of the insulation resistance can be sensed, in a state where a pulse signal is applied to a series circuit configured to include a detecting resistor, a coupling capacitor and an insulation resistance, based on a pulse-like divided voltage divided by the detecting resistor and the insulation resistance. It is further disclosed that, by inputting the pulse-like divided voltage into a low-pass filter and changing the frequency of a pulse signal, a failure of the insulation resistance drop detector itself can be detected based on the rising characteristics of an output voltage from the low-pass filter.

However, with the configuration of the insulation resistance drop detector disclosed in Patent Document 1, a failure of the insulation resistance drop detector itself cannot be sensed.

Further, with the insulation resistance drop detector disclosed in Patent Document 2, a low-pass filter is required for the failure self-diagnosis function that is a function of detecting a failure of itself, the number of components constituting the circuit is increased.

### Disclosure of the Invention

The present invention has been made to solve the above-described problems, and an object thereof is to provide an insulation resistance drop detector having a failure self-diagnosis function realized by a simple configuration, and a failure self-diagnosis method therefor.

An insulation resistance drop detector according to the present invention detects a drop of an insulation resistance of an insulated power supply. The insulation resistance drop detector includes a coupling capacitor, a detecting resistor, a voltage detector, and a control circuit. The detecting resistor is serially connected to the insulation resistance via the coupling capacitor. The voltage detector detects a voltage at a connecting point between the coupling capacitor and the detecting resistor. The control circuit detects the drop of the insulation resistance based on the voltage detected by the voltage detector. The control circuit senses a failure of the insulation resistance drop detector itself when the voltage detected by the voltage detector is maintained at least at a prescribed voltage exceeding a prescribed period.

A failure self-diagnosis method for an insulation resistance drop detector according to the present invention is a failure self-diagnosis method for an insulation resistance drop detector detecting a drop of an insulation resistance of an insulated power supply. The insulation resistance drop detector includes a coupling capacitor, a detecting resistor serially connected to the insulation resistance via the coupling capacitor, a voltage detector detecting a voltage at a connecting point between the coupling capacitor and the detecting resistor, and a control circuit detecting the drop of the insulation resistance based on the voltage detected by the voltage detector. The method includes a first step of determining whether the voltage detected by the voltage detector is maintained at least at a prescribed voltage exceeding a prescribed period, and a second step of sensing a failure of the insulation resistance drop detector itself when it is determined in the first step that the detected voltage is maintained at least at the prescribed voltage exceeding the prescribed period.

According to the insulation resistance drop detector and the failure self-diagnosis method therefor, by sensing the division ratio of the detecting resistor and the insulation resistance from the voltage at the connecting point, a drop of an insulation resistance can be detected. Further, when the detected value of the voltage at the connecting point is fixed to a voltage of at least a prescribed voltage exceeding a prescribed period, a failure of the insulation resistance drop detector itself is detected. As a result, without the necessity of adding a new circuit, a failure self-diagnosis function detecting a short-circuiting failure with the power supply voltage in the insulation resistance drop detector can be provided by a simple configuration.

Preferably, the insulation resistance drop detector further includes a pulse generator. The pulse generator applies a pulse signal to a series circuit configured to include the insulation resistance, the coupling capacitor and the detecting resistor. The control circuit senses the failure of the insulation resistance drop detector itself when the voltage detected by the voltage detector is maintained at least at the prescribed voltage over a plurality of cycles of the pulse signal.

Preferably, in the failure self-diagnosis method for the insulation resistance drop detector according to the present invention, the insulation resistance drop detector further includes a pulse generator applying a pulse signal to a series circuit configured to include the insulation resistance, the coupling capacitor and the detecting resistor, and in the first step, it is determined that the detected voltage is maintained at least at the prescribed voltage exceeding the prescribed period when the voltage detected by the voltage detector is maintained at least at the prescribed voltage over a plurality of cycles of the pulse signal.

According to the insulation resistance drop detector and the failure self-diagnosis method therefor, a failure is sensed when the voltage at the connecting point, which normally should change in a pulse manner in accordance with the cycles of a pulse signal, is fixed to a voltage that is at least a prescribed voltage over a plurality of cycles of the pulse signal. Therefore, a failure (short-circuiting failure with the power supply voltage) of an insulation resistance drop detector can correctly be sensed.

An insulation resistance drop detector according to the present invention detects a drop of an insulation resistance of an insulated power supply. The insulation resistance drop detector includes a coupling capacitor, a detecting resistor, a voltage detector, a control circuit, and a noise generator. The detecting resistor is serially connected to the insulation resistance via the coupling capacitor. The voltage detector detects a voltage at a connecting point between the coupling capacitor and the detecting resistor. The control circuit detects the drop of the insulation resistance based on the voltage detected by the voltage detector. The noise generator controls a circuit system connected to the power supply so as to generate a noise of a prescribed frequency in a period specified by the control circuit. The control circuit senses a failure of the insulation resistance drop detector itself when a voltage change due to the noise is not sensed in the voltage at the connecting point during a period in which the noise is generated by the noise generator as compared with the voltage at the connecting point before the noise is generated.

A failure self-diagnosis method for an insulation resistance drop detector according to the present invention is a failure self-diagnosis method for an insulation resistance drop detector detecting a drop of an insulation resistance of an insulated power supply, the insulation resistance drop detector including a coupling capacitor, a detecting resistor serially connected to an insulation resistance via the coupling capacitor, a voltage detector detecting a voltage at a connecting point between the coupling capacitor and the detecting resistor, a control circuit detecting the drop of the insulation resistance based on the voltage detected by the voltage detector, and a noise generator controlling a circuit system connected to the power supply so as to generate a noise of a prescribed frequency in a specified period, the method comprising: a first step of specifying generation of the noise to the noise generator; a second step of determining whether a voltage change due to the noise is sensed in the voltage at the connecting point during a period in which the generation of noise is specified in the first step as compared with the voltage before the noise is generated; and a third step of sensing a failure of the insulation resistance drop detector itself when the voltage change due to the noise is not sensed in the voltage at the connecting point in the second step.

According to the insulation resistance drop detector and the failure self-diagnosis method therefor, by sensing the division ratio of the detecting resistor and the insulation resistance from the voltage at the connecting point, a drop of an insulation resistance can be detected. Further, a self-diagnosis period in which a noise is forcibly generated in the power supply circuit system is provided, and when a voltage change due to the noise is not sensed in the voltage at the connecting point during this diagnosis period, a failure of the insulation resistance drop detector itself is detected. As a result, without the necessity of adding a new circuit, a failure self-diagnosis function detecting a disconnection failure inside the insulation resistance drop detector or at the connection to the power supply can be provided by a simple configuration.

Preferably, in the insulation resistance drop detector and a failure self-diagnosis method therefor according to the present invention, the insulation resistance drop detector further includes a pulse generator. The pulse generator applies a pulse signal to a series circuit configured to include the insulation resistance, the coupling capacitor and the detecting resistor. The circuit system connected to the power supply includes first and second inverters. The first and second inverters convert direct-current power from the power supply into alternating-current power by a switching operation of a power semiconductor device based on pulse width modulation control. Specifically, during a period in which the noise is generated by the noise generator, a first carrier wave used for the pulse width modulation control at the first inverter and a second carrier wave used for the pulse width modulation at the second inverter are set at separate frequencies.

Employing such a configuration, without the necessity of providing a new circuit, a forcible noise for failure self-diagnosis for the insulation resistance drop detector can be generated using a configuration that is used for normal inverter control.

Preferably, the period in which the noise is generated by the noise generator is set to a time of activating the circuit system connected to the power supply.

Employing such a configuration, whether a disconnection failure occurs in the insulation resistance drop detector can be checked when use of the power supply is started.

Alternatively and further preferably, the power supply and the insulation resistance drop detector are incorporated in a vehicle, and the period in which the noise is generated by the noise generator is set to a time of stopping the vehicle.

Employing such a configuration, without generating a noise while the vehicle is driven, the failure self-diagnosis of the insulation resistance drop detector can be executed.

Further preferably, the power supply and the insulation resistance drop detector are incorporated in a vehicle, and the power supply is insulated from a vehicle body of the vehicle.

Employing such a configuration, a failure of the insulation resistance drop detector can be sensed, which is important in preventing the electric shock to a person touching the vehicle body. In particular, the suitability of the insulation resistance drop detector to the on-board application is improved, since the failure self-diagnosis function can be provided without the necessity of providing a new circuit.

Accordingly, the substantial advantage of the present invention is that it becomes possible to provide the insulation resistance drop detector with the failure self-diagnosis function by a simple configuration.

### Brief Description of the Drawings

Fig. 1 is a block diagram representing a configuration of an insulation resistance drop detector according to a first embodiment of the present invention.
Fig. 2 is a waveform diagram representing a voltage waveform detected by the voltage detector shown in Fig. 1.
Fig. 3 is a flowchart representing a failure self-diagnosis function of the insulation resistance drop detector according to the first embodiment.
Fig. 4 is a block diagram representing a configuration of an insulation resistance drop detector according to a second embodiment of the present invention.
Fig. 5 is a waveform diagram related to a description of pulse width modulation (PWM) control at the inverters shown in Fig. 4.
Fig. 6 is a block diagram representing one example of a carrier wave generation mechanism of the inverter control portion shown in Fig. 4.
Fig. 7 is a flowchart representing a failure self-diagnosis function of the insulation resistance drop detector according to the second embodiment.

### Best Modes for Carrying Out the Invention

In the following, embodiments of the present invention will be described in detail referring to the drawings. Identical reference characters are allotted to identical or corresponding parts throughout the drawings, and detailed description thereof will not basically be repeated.

### First Embodiment

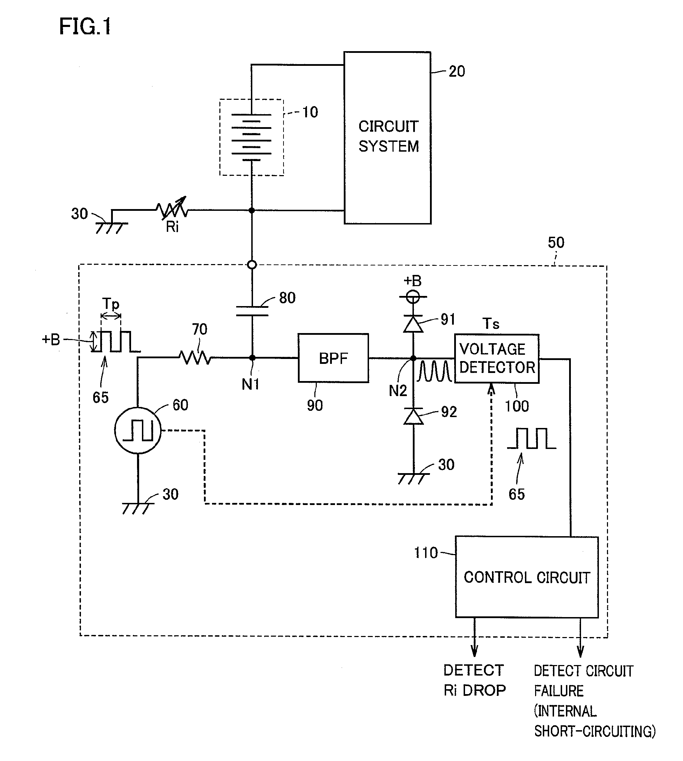

Referring to Fig. 1, an insulation resistance drop detector 50 according to a first embodiment of the present invention detects a drop of an insulation resistance Ri to an earth 30 of a DC (direct-current) power supply 10. To DC power supply 10, a circuit system 20 that is supplied with a power supply voltage from DC power supply 10 to operate is connected. DC power supply 10 is an electric storage apparatus such as a secondary battery, a fuel cell or a capacitor that is used as a motor power supply for driving a vehicle as incorporated in an electric vehicle, a hybrid vehicle or the like, for example.

In the instance of such a vehicle, earth 30 corresponds to the vehicle body. A person touching vehicle body 30 may receive an electric shock if insulation resistance Ri drops, and therefore it is critical from a viewpoint of safety to detect the drop of insulation resistance Ri. Accordingly, it is necessary not only to detect a drop of insulation resistance Ri by insulation resistance drop detector 50, but also to determine whether insulation resistance drop detector 50 itself is normal. Considering its incorporation in a vehicle, it is preferable to reduce the size of insulation resistance drop detector 50 to improve its suitability to such an on-board application.

Insulation resistance drop detector 50 includes a pulse generator 60, a detecting resistor 70, a coupling capacitor 80, a bandpass filter 90, overvoltage protection diodes 91 and 92, a voltage detector 100, and a control circuit 110.

Pulse generator 60 generates a pulse signal 65 of a prescribed frequency (prescribed cycle Tp). Detecting resistor 70 is connected between pulse generator 60 and a node N1. Coupling capacitor 80 is connected between power supply 10 of which leakage is to be detected and node N1. Bandpass filter 90 is connected between node N1 and a node N2. The pass band frequency of bandpass filter 90 is designed in accordance with the frequency of pulse signal 65.

Overvoltage protection diodes 91 and 92 connected to node N2 remove a surge voltage (a high voltage, a negative voltage). Voltage detector 100 detects the voltage of node N2 with a prescribed sampling cycle Ts. Sampling cycle Ts of voltage detector 100 is set sufficiently shorter than cycle Tp of pulse signal 65 so that cyclic changes in the voltage of node N2 responding to pulse signal 65 can be detected. Thus, the maximum voltage (peak voltage), minimum voltage or the like in the pulse voltage cycle corresponding to the pulse signal cycle can be sensed. The maximum voltage (peak voltage), minimum voltage or the like may be sensed by inputting pulse signal 65 from pulse generator 60 into voltage detector 100 and setting a voltage sampling timing of node N2 considering synchronization with pulse signal 65.

By the scheme described in the following, control circuit 110 detects whether or not there is a drop of insulation resistance Ri and a circuit failure (internal short-circuit) of insulation resistance drop detector 50 itself, based on the voltage of node N2 detected by voltage detector 100.

Control circuit 110 detects a drop of insulation resistance Ri and a circuit failure of insulation resistance drop detector 50, based on the voltage of node N2 detected by voltage detector 100 according to sampling cycle Ts. The operation of control circuit 110 can be processed in a software-like manner, generally with a microcomputer or the like. Accordingly, control circuit 110 can be realized as one function of an electronic control unit (ECU).

Next, the operation of insulation resistance drop detector 50 is described.

Pulse signal 65 generated by pulse generator 60 is applied to a series circuit configured to include detecting resistor 70, coupling capacitor 80 and an insulation resistance Ri. Thus, at node N1 corresponding to the connecting point between detecting resistor 70 and coupling capacitor 80, a pulse voltage is generated, which has a crest value corresponding to a product of a division ratio of insulation resistance Ri and detecting resistor 70 (resistance value Rd), i.e., Ri/(Rd+Ri), and an amplitude (power supply voltage +B) of pulse signal 65.

The pulse voltage generated at node N1 has its components other than the frequency of pulse signal 65 attenuated by bandpass filter 90, and has its surge voltage removed by overvoltage protection diodes 91 and 92, and then it is transmitted to node N2.

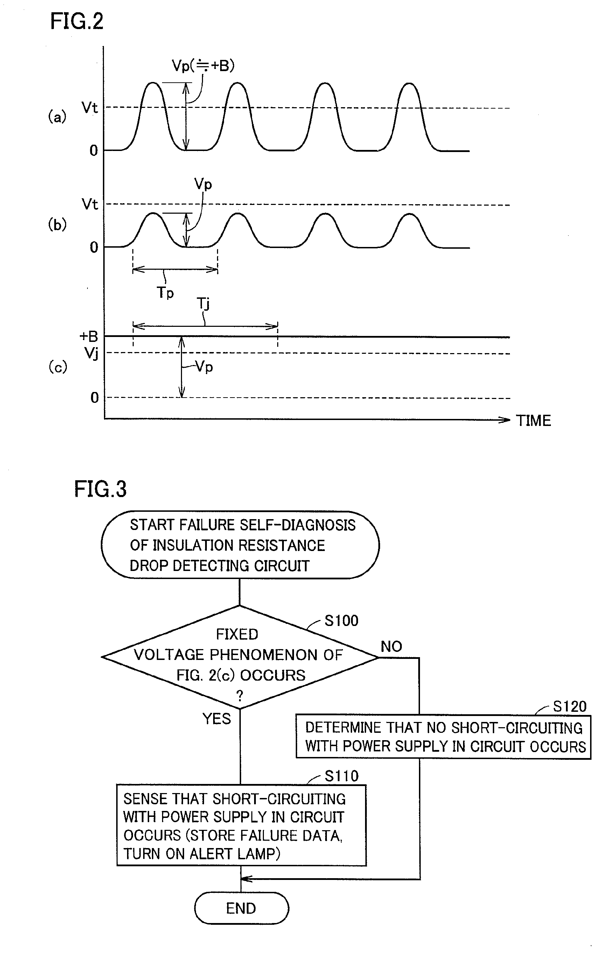

Fig. 2(a) shows a voltage waveform of node N2 when an insulation resistance is normal.

When insulation resistance Ri is normal, Ri >> Rd. Accordingly, as shown in Fig. 2(a), at node N2, a pulse voltage having peak voltage Vp substantially equal to power supply voltage +B is generated.

On the other hand, when insulation resistance Ri drops, the division ratio, i.e., Ri/(Rd+Ri), drops. Thus, as shown in Fig. 2(b), peak voltage Vp of the pulse voltage of cycle Tp drops. Therefore, determining a threshold voltage Vt according to the division ratio of an allowable lower limit value of insulation resistance Ri and detecting resistance Rd, a drop of insulation resistance Ri can be detected based on the comparison between peak voltage Vp occurring at node N2 and threshold voltage Vt.

When a failure in which a wire or the like is short-circuited with power supply voltage +B occurs inside insulation resistance drop detector 50, as shown in Fig. 2(c), the detected voltage at node N2 is fixed to power supply voltage +B. In such a case, the detection of an insulation resistance drop cannot normally be executed. On the other hand, since the peak voltage exceeds threshold voltage Vt in this case, it is necessary to detect a failure of insulation resistance drop detector 50 itself while not erroneously determining that the insulation resistance is normal.

Fig. 3 is a flowchart representing a failure self-diagnosis function of the insulation resistance drop detector.

Referring to Fig. 3, in step S100, control circuit 110 determines whether or not the fixed voltage phenomenon of Fig. 2(c) occurs. For example, control circuit 110 determines whether or not the detected voltage at node N2 is maintained at least at determination value Vj exceeding a prescribed period Tj, thereby realizing the determination of step S100. Here, determination value Vj is set around power supply voltage +B so that short-circuiting with power supply voltage +B can be sensed. Prescribed period Tj is set so as to include a plurality of cycles Tp of pulse signal 65.

When the fixed voltage phenomenon is detected (YES in S 100), control circuit 110 senses in step S 110 a failure of insulation resistance drop detector 50 itself (occurrence of short-circuiting with the power supply in the circuit). It further stores failure data (occurrence of short-circuiting with the power supply in the circuit) and let the driver know that there is a failure occurring in the insulation resistance drop detector, by turning an alert lamp on, for example.

On the other hand, when the fixed voltage phenomenon is not detected (NO in S100), control circuit 110 determines in step S120 that the short-circuiting with the power supply in the circuit is not occurring. In this case, as described referring to Fig. 2(a) and (b), a drop of insulation resistance Ri can be detected based on the comparison between peak voltage Vp and threshold voltage Vt.

As described above, with insulation resistance drop detector 50 according to the first embodiment, a drop of insulation resistance Ri can be detected by applying a pulse signal, and also can provide insulation resistance drop detector 50 with a failure self-diagnosis function. Thus, even when a short-circuiting failure with power supply voltage +B is occurring in insulation resistance drop detector 50, an erroneous determination that the insulation resistance is normal is not made, and a failure in insulation resistance drop detector 50 itself can be detected. In particular, since the failure self-diagnosis function can be provided by the determination processing by control circuit 110 without the necessity of adding a new circuit element, insulation resistance drop detector 50 can be reduced in size to improve suitability to the on-board application.

### Second Embodiment

In a second embodiment, a configuration is described that can sense a failure of a disconnection between power supply 10 of which leakage is sensed and coupling capacitor 80, by an insulation resistance drop detector having a circuit configuration similarly to that in the first embodiment.

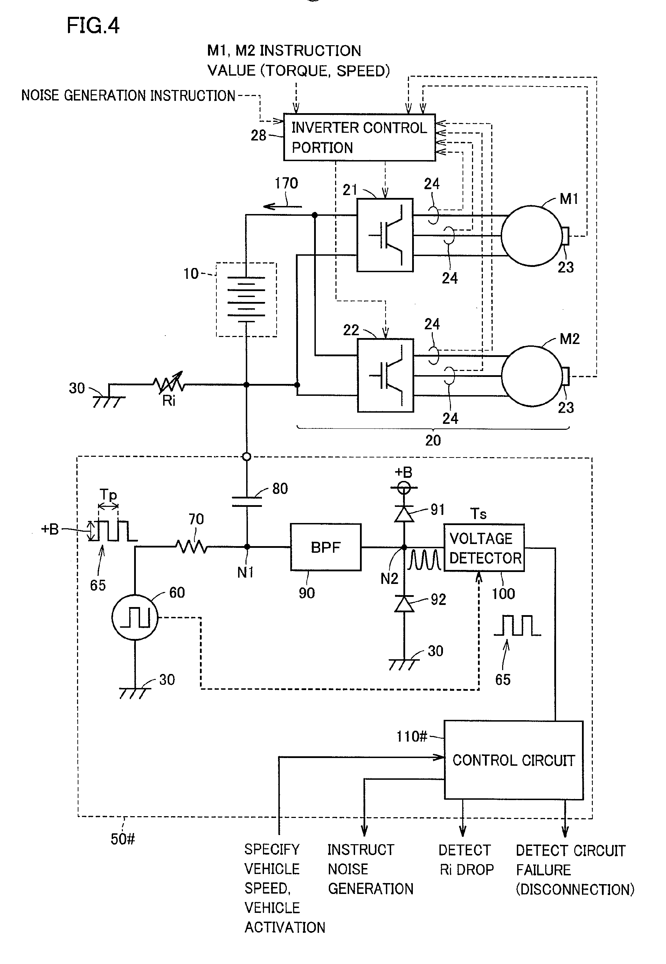

Fig. 4 is a block diagram showing a configuration of an insulation resistance drop detector 50# according to the second embodiment of the present invention.

Referring to Fig. 4, as compared, insulation resistance drop detector 50# is different from insulation resistance drop detector 50 shown in Fig. 1 in that it is provided with a control circuit 110# in place of control circuit 110. Similarly to control circuit 110, the operation of control circuit 110# can be processed in a software-like manner, generally with a microcomputer or the like. Therefore, insulation resistance drop detector 50# shown in Fig. 3 has the circuit configuration similarly to that of insulation resistance drop detector 50 shown in Fig. 1, and it is realized by changing a program of an electronic control unit (ECU).

In the second embodiment, a circuit system 20 connected to a power supply 10, of which insulation resistance is to be monitored, includes motors M1 and M2, inverters 21 and 22 respectively driving motors M1 and M2, and an inverter control portion 28 controlling the operation of inverters 21 and 22.

By the switching operation of accommodated power semiconductor switching elements, inverters 21 and 22 convert DC power supplied from power supply 10 into AC power and supplies it to motors M1 and M2. Motors M1 and M2 are provided as appropriate with position sensors 23 detecting the rotation phase of the rotor, and a current sensors 24 detecting respective phase currents supplied to motors M1 and M2.

Inverter control portion 28 controls the switching operation in inverters 21 and 22 based on values detected by position sensors 23 and current sensors 24 so that motors M1 and M2 are driven according to instruction values (torque, speed).

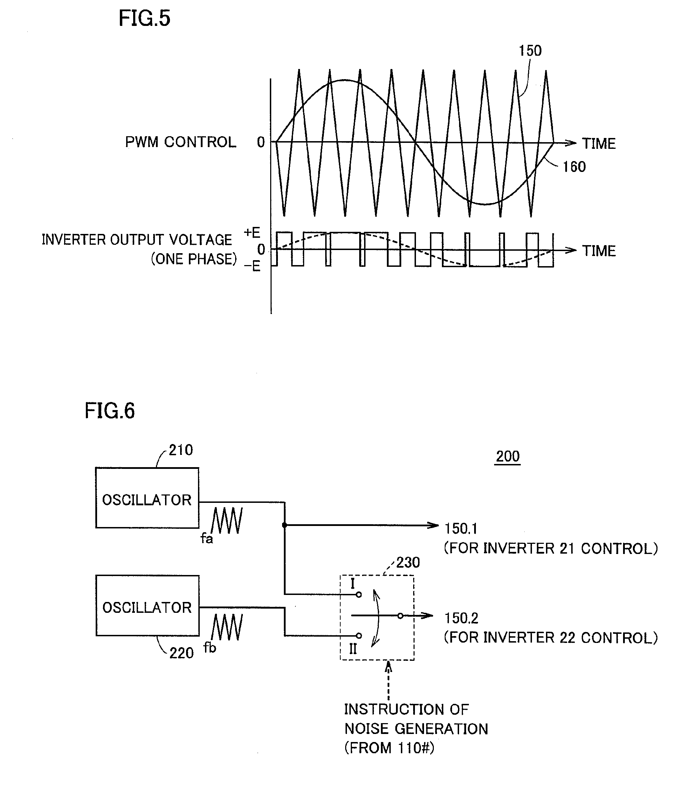

General three-phase inverters configured using power semiconductor switching elements can be employed as inverters 21 and 22, and therefore their detailed configuration is not described herein. Generally, pulse width modulation (PWM) control as shown in Fig. 5 is applied as the switching control in such inverters. In PWM control, a pulse width of a square wave output voltage is changed by a certain cycle so that the output voltage average for each cycle is changed. Generally, by dividing a certain cycle into a plurality of switching cycles corresponding to cycles of a carrier wave, and exerting ON/OFF control of the power semiconductor switching element for each switching cycle, the pulse width modulation control is achieved.

Referring to Fig. 5, in the PWM control of inverters 21 and 22, signal wave 160 that follows an AC voltage instruction (in each phase) to be applied to motors M1 and M2 is compared with carrier wave 150 of a prescribed frequency. By switching ON/OFF of the power semiconductor switching element in each phase arm between a section in which the carrier wave voltage is higher than the signal wave voltage and a section in which the signal wave voltage is higher than the carrier wave voltage, it becomes possible to provide motors M1 and M2 with the AC voltage of a combined square wave voltage, as the inverter output voltage of each phase. The fundamental wave component of the AC voltage is indicated by the dashed line in Fig. 5. That is, the frequency of carrier wave 150 corresponds to the switching frequency of inverters 21 and 22.

While carrier waves 150 respectively used for PWM control of inverters 21 and 22 are set to the identical frequency when normally controlled, the frequencies are intentionally displaced from each other herein. Thus, as shown in Fig. 4, noise 170 corresponding to the frequency difference can forcibly be generated in circuit system 20.

Fig. 6 shows one example of a carrier wave generating mechanism of inverter control portion 28.

Referring to Fig. 6, carrier wave generating mechanism 200 includes an oscillator 210 generating a carrier wave of frequency fa, an oscillator 220 generating a carrier wave of frequency fb, and a switch 230. Normally, the switch is controlled to be on I side, so that carrier wave 150.1 used for PWM control of inverter 21 and carrier wave 150.2 used for PWM control of inverter 22 are at the identical frequency fa.

On the other hand, when a noise generation instruction is issued by control circuit 110#, the switch is controlled to be on II side. Thus, the frequency of carrier wave 150.1 to be used for PWM control of inverter 21 and the frequency of carrier wave 150.2 to be used for PWM control of inverter 22 are forcibly displaced, whereby a noise is forcibly generated. Here, the frequency difference (fa - fb) between carrier waves 150 is designed such that a noise frequency is equivalent to the frequency of pulse signal 65 (that is, the pass band frequency of bandpass filter 90).

Referring to Fig. 4 again, noise 170 forcibly generated at circuit system 20 is transmitted, via power supply 10 and coupling capacitor 80, to node N1 of insulation resistance drop detector 50#. Thus, a voltage change due to the effect of noise 170 occurs in node N1. By setting the noise frequency to be equivalent to the frequency of pulse signal 65, the voltage change is transmitted to node N2 and sensed by voltage detector 100.

On the other hand, when a disconnection failure is occurring in the connection by coupling capacitor 80 and coupling capacitor 80 is not normally connected to power supply 10 of which insulation resistance is to be monitored, noise 170 forcibly generated at circuit system 20 does not affect the voltage at node N1. Therefore, no voltage change due to the effect of noise is sensed by voltage detector 100.

Accordingly, with insulation resistance drop detector 50#, in a prescribed failure self-diagnosis period, by creating a noise generation instruction by control circuit 110# to determine whether or not a voltage change due to the effect of noise 170 generated at circuit system 20 occurs, whether a disconnection failure occurs in the connection with power supply 10 via coupling capacitor 80, or in insulation resistance drop detector 50# is sensed.

When the disconnection failure occurs, even when insulation resistance Ri drops, the peak voltage of the pulse voltage at node N1 does not drop. Accordingly, the insulation resistance drop detection cannot be executed normally, and an erroneous determination that the insulation resistance is normal may be made in this case. Therefore, it is necessary to detect the failure of insulation resistance drop detector 50 itself.

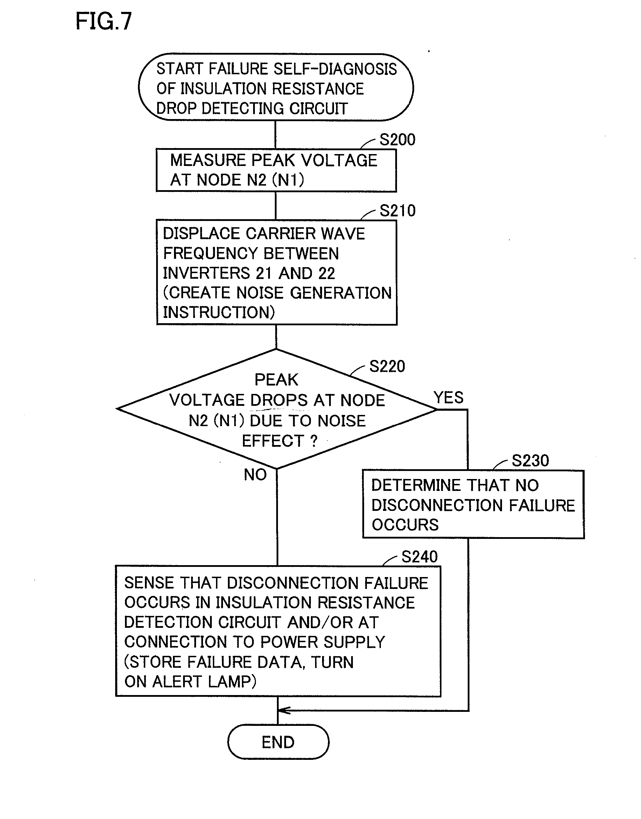

Fig. 7 is a flowchart representing a failure self-diagnosis for detecting a disconnection by insulation resistance drop detector 50#.

Referring to Fig. 7, in step S200, control circuit 110# measures the peak voltage at node N2 before a failure self-diagnosis period, that is, before noise 170 is forcibly generated.

Thereafter, in step S210, control circuit 110# generates forcible noise 170 in circuit system 20, by generating a noise generation instruction and thereby displacing the carrier wave frequencies between inverters 21 and 22.

Further, in step S220, control circuit 110# determines whether or not a voltage change due to noise 170 occurs at node N1. Specifically, it compares the peak voltage at node N2 in the failure self-diagnosis period with the peak voltage before the failure self-diagnosis period measured in step S200, to determine whether or not a drop of the peak voltage occurs. That is, determination is made according to the voltage measured by voltage detector 100 as to whether or not the peak voltage value of node N2 drops because of the voltage being lowered by the noise passing through node N1 in the period in which noise 170 is generated (failure self-diagnosis period), relative to the pulse voltage at node N1 (N2) as shown in Fig. 2(a) before noise generation.

When peak voltage drop at node N2 in the noise generation period is not detected (YES in step S220), in step S230, control circuit 110# determines that no disconnection failure occurs in insulation resistance drop detector 50# and terminates the failure self-diagnosis. In this case, since insulation resistance drop detector 50# is normally operating, a drop of insulation resistance Ri can be detected based on a comparison between peak voltage Vp and threshold voltage Vt as described in the first embodiment.

On the other hand, when no peak voltage drop at node N2 in the noise generation period is detected (NO in step S220), in step S240, control circuit 110# senses that a disconnection failure occurs in insulation resistance drop detector 50#. It further stores failure data (occurrence of disconnection in the circuit) and let the driver know that there is a failure occurring in the insulation resistance drop detector, by turning an alert lamp on or the like.

As described above, with insulation resistance drop detector 50# according to the second embodiment, a drop of insulation resistance Ri can be detected by applying a pulse signal. Further, even when a disconnection failure is occurring in insulation resistance drop detector 50# or in the connection to power supply 10, a failure in insulation resistance drop detector 50# itself can be detected without erroneously determining that the insulation resistance is normal. Thus, since the failure self diagnosis function can be provided by the determination processing by control circuit 110 without the necessity of adding a new circuit element, insulation resistance drop detector 50# can be reduced in size to improve suitability to the on-board application.

It is noted that the timing of generating the noise generation instruction by control circuit 110#, that is, the failure self-diagnosis period, can be provided at the activation timing of circuit system 20 at which circuit system 20 is supplied with power from power supply 10 and activated. Alternatively, when power supply 10 is incorporated in a vehicle such as an electric vehicle, a hybrid vehicle or the like, a desirable configuration is that the failure self-diagnosis of the insulation resistance drop detector by forcible noise generation is executed only when the vehicle is stopped.

Forcible noise 170 for the failure self-diagnosis of insulation resistance drop detector 50# can be generated by a scheme other than the scheme of providing a displacement in the carrier wave frequency change of the inverters as described referring to Figs. 4-6. It should be noted that, with a configuration such as shown in Fig. 4 where power supply 10 is shared by a plurality of inverters, it is possible to generate forcible noise 170 for failure self-diagnosis without adding a new circuit element by the scheme described above.

As described above, the functions of control circuits 110 and 110# can be realized by software of a microcomputer or the like. Accordingly, it is also possible to form an insulation resistance detector that executes both the failure self-diagnosis according to the flowchart of Fig. 3 (the first embodiment) and that according to the flowchart of Fig. 7 (the second embodiment).

It should be understood that the embodiments disclosed herein are illustrative and non-restrictive in every respect. The scope of the present invention is defined by the terms of the claims, rather than the description and example above, and is intended to include any modifications and changes within the scope and meaning equivalent to the terms of the claims.

### Industrial Applicability

The insulation resistance drop detector and the insulation resistance drop detection method according to the present invention can be applied to a device having a high voltage power supply, representatively.

## Claims

1. An insulation resistance drop detector detecting a drop of an insulation resistance of an insulated power supply, comprising:
a coupling capacitor;
a detecting resistor serially connected to said insulation resistance via said coupling capacitor;
voltage detecting means for detecting a voltage at a connecting point between said coupling capacitor and said detecting resistor; and
control means for detecting the drop of said insulation resistance based on the voltage detected by said voltage detecting means, wherein
said control means includes failure sensing means for sensing a failure of said insulation resistance drop detector itself when the voltage detected by said voltage detecting means is maintained at least at a prescribed voltage exceeding a prescribed period.

2. The insulation resistance drop detector according to claim 1, further comprising pulse generating means for applying a pulse signal to a series circuit configured to include said insulation resistance, said coupling capacitor and said detecting resistor, wherein
said failure sensing means senses the failure of said insulation resistance drop detector itself when the voltage detected by said voltage detecting means is maintained at least at said prescribed voltage over a plurality of cycles of said pulse signal.

3. An insulation resistance drop detector detecting a drop of an insulation resistance of an insulated power supply, comprising:
a coupling capacitor;
a detecting resistor serially connected to said insulation resistance via said coupling capacitor;
voltage detecting means for detecting a voltage at a connecting point between said coupling capacitor and said detecting resistor;
control means for detecting the drop of said insulation resistance based on the voltage detected by said voltage detecting means; and
noise generating means for specifying generation of a noise of a prescribed frequency in a circuit system connected to said power supply, wherein
said control means includes means for sensing a failure of said insulation resistance drop detector itself when a voltage change due to said noise is not sensed in the voltage at the connecting point during a period in which said noise is generated by said noise generating means as compared with the voltage at the connecting point before said noise is generated.

4. The insulation resistance drop detector according to claim 3, further comprising pulse generating means for applying a pulse signal to a series circuit configured to include said insulation resistance, said coupling capacitor and said detecting resistor, wherein
said circuit system includes first and second inverters that convert direct-current power from said power supply into alternating-current power by a switching operation of a power semiconductor device based on pulse width modulation control, and
during a period in which generation of said noise is specified by said noise generating means, a first carrier wave used for said pulse width modulation control at said first inverter and a second carrier wave used for said pulse width modulation at said second inverter are set at separate frequencies.

5. The insulation resistance drop detector according to claim 3 or 4, wherein
said period in which said noise is generated by said noise generating means is set to a time of activating said circuit system.

6. The insulation resistance drop detector according to claim 3 or 4, wherein
said power supply and said insulation resistance drop detector are incorporated in a vehicle, and
said period in which said noise is generated by said noise generating means is set to a time of stopping said vehicle.

7. The insulation resistance drop detector according to one of claims 1-4, wherein
said power supply and said insulation resistance drop detector are incorporated in a vehicle, and
said power supply is insulated from a vehicle body of said vehicle.

8. An insulation resistance drop detector detecting a drop of an insulation resistance of an insulated power supply, comprising:
a coupling capacitor;
a detecting resistor serially connected to said insulation resistance via said coupling capacitor;
a voltage detector detecting a voltage at a connecting point between said coupling capacitor and said detecting resistor; and
a control circuit detecting the drop of said insulation resistance based on the voltage detected by said voltage detector, wherein
said control circuit senses a failure of said insulation resistance drop detector itself when the voltage detected by said voltage detector is maintained at least at a prescribed voltage exceeding a prescribed period.

9. The insulation resistance drop detector according to claim 8, further comprising a pulse generator applying a pulse signal to a series circuit configured to include said insulation resistance, said coupling capacitor and said detecting resistor, wherein
said control circuit senses the failure of said insulation resistance drop detector itself when the voltage detected by said voltage detector is maintained at least at said prescribed voltage over a plurality of cycles of said pulse signal.

10. An insulation resistance drop detector detecting a drop of an insulation resistance of an insulated power supply, comprising:
a coupling capacitor;
a detecting resistor serially connected to said insulation resistance via said coupling capacitor;
a voltage detector detecting a voltage at a connecting point between said coupling capacitor and said detecting resistor;
a control circuit detecting the drop of said insulation resistance based on the voltage detected by said voltage detector; and
a noise generator controlling a circuit system connected to said power supply so as to generate a noise of a prescribed frequency in a period specified by said control circuit, wherein
said control circuit senses a failure of said insulation resistance drop detector itself when a voltage change due to said noise is not sensed in the voltage at the connecting point during a period in which said noise is generated by said noise generator as compared with the voltage at the connecting point before said noise is generated.

11. The insulation resistance drop detector according to claim 10, further comprising a pulse generator applying a pulse signal to a series circuit configured to include said insulation resistance, said coupling capacitor and said detecting resistor, wherein
said circuit system includes first and second inverters that convert direct-current power from said power supply into alternating-current power by a switching operation of a power semiconductor device based on pulse width modulation control, and
during the period in which said noise is generated by said noise generator, a first carrier wave used for said pulse width modulation control at said first inverter and a second carrier wave used for said pulse width modulation at said second inverter are set at separate frequencies.

12. The insulation resistance drop detector according to claim 10 or 11,
wherein said period in which said noise is generated by said noise generator is set to a time of activating said circuit system.

13. The insulation resistance drop detector according to claim 10 or 11, wherein
said power supply and said insulation resistance drop detector are incorporated in a vehicle, and
said period in which said noise is generated by said noise generator is set to a time of stopping said vehicle.

14. The insulation resistance drop detector according to one of claims 8-11, wherein
said power supply and said insulation resistance drop detector are incorporated in a vehicle, and
said power supply is insulated from a vehicle body of said vehicle.

15. A failure self-diagnosis method for an insulation resistance drop detector detecting a drop of an insulation resistance of an insulated power supply, said insulation resistance drop detector including a coupling capacitor, a detecting resistor serially connected to said insulation resistance via said coupling capacitor, a voltage detector detecting a voltage at a connecting point between said coupling capacitor and said detecting resistor, and a control circuit detecting the drop of said insulation resistance based on the voltage detected by said voltage detector, said method comprising:
a first step of determining whether the voltage detected by said voltage detector is maintained at least at a prescribed voltage exceeding a prescribed period; and
a second step of sensing a failure of said insulation resistance drop detector itself when it is determined in the first step that the detected voltage is maintained at least at the prescribed voltage exceeding the prescribed period.

16. The failure self-diagnosis method for the insulation resistance drop detector according to claim 15, wherein
said insulation resistance drop detector further includes a pulse generator applying a pulse signal to a series circuit configured to include said insulation resistance, said coupling capacitor and said detecting resistor, and
in said first step, it is determined that said detected voltage is maintained at least at the prescribed voltage exceeding the prescribed period when the voltage detected by said voltage detector is maintained at least at said prescribed voltage over a plurality of cycles of said pulse signal.

17. A failure self-diagnosis method for an insulation resistance drop detector detecting a drop of an insulation resistance of an insulated power supply, said insulation resistance drop detector including a coupling capacitor, a detecting resistor serially connected to said insulation resistance via said coupling capacitor, a voltage detector detecting a voltage at a connecting point between said coupling capacitor and said detecting resistor, a control circuit detecting the drop of said insulation resistance based on the voltage detected by said voltage detector, and a noise generator controlling a circuit system connected to said power supply so as to generate a noise of a prescribed frequency in a specified period, said method comprising:
a first step of specifying generation of said noise to said noise generator;
a second step of determining whether a voltage change due to said noise is sensed in said voltage at the connecting point during a period in which said generation of noise is specified in the first step as compared with said voltage before said noise is generated; and
a third step of sensing a failure of said insulation resistance drop detector itself when the voltage change due to said noise is not sensed in said voltage at the connecting point in said second step.

18. The failure self-diagnosis method for the insulation resistance drop detector according to claim 17, wherein
said insulation resistance drop detector further includes a pulse generator applying a pulse signal to a series circuit configured to include said insulation resistance, said coupling capacitor and said detecting resistor,
said circuit system includes first and second inverters that convert direct-current power from said power supply into alternating-current power by a switching operation of a power semiconductor device based on pulse width modulation control, and
during a period in which said noise is generated by said noise generator, a first carrier wave used for said pulse width modulation control at said first inverter and a second carrier wave used for said pulse width modulation at said second inverter are set at separate frequencies.

19. The failure self-diagnosis method for the insulation resistance drop detector according to claim 17 or 18, wherein said period in which said noise is generated by said noise generator is set to a time of activating said circuit system.

20. The insulation resistance drop detector according to claim 17 or 18, wherein
said power supply and said insulation resistance drop detector are incorporated in a vehicle, and
said period in which said noise is generated by said noise generator is set to a time of stopping said vehicle.

21. The insulation resistance drop detector according to one of claims 15-18, wherein
said power supply and said insulation resistance drop detector are incorporated in a vehicle, and
said power supply is insulated from a vehicle body of said vehicle.
